# DEMANDE DE BREVET EUROPEEN

(11) **EP 0 961 318 A1**
(43) Date de publication de la demande: **01.12.1999**
(21) Numéro de dépôt: 99401205.2
(22) Date de dépôt: 19.05.1999
(51) Int. Cl.: H01L 21/768, H01L 23/522

(54) **Circuit intégré avec couche d'arrêt**

(30) Priorité: 27.05.1998 FR 9806687
(71) Demandeur: STMicroelectronics SA, 94250 Gentilly Cedex (FR); FRANCE TELECOM, 75015 Paris (FR)
(72) Inventeur: Gayet, Philippe, 38660 St. Vincent de Mercuze (FR); Granger, Eric, 38920 Crolles (FR)
(74) Mandataire: Casalonga, Axel

(57) **Abrégé**

Procédé de fabrication d'un circuit intégré dans lequel on dépose une deuxième couche diélectrique sur une première couche diélectrique, la deuxième couche diélectrique étant susceptible d'être gravée de façon sélective par rapport à la première couche diélectrique, on effectue la gravure de trous ou de tranchées dans les première et deuxième couches diélectriques, et leur remplissage de métal pour constituer des motifs formant des connexions électriques, et on dépose au moins une troisième couche diélectrique. On effectue la gravure de trous ou de tranchées dans la troisième couche diélectrique et dans la couche diélectrique adjacente et inférieure de façon sélective par rapport à la couche diélectrique suivante et aux motifs pour contrôler la profondeur de la gravure.

## Description

La présente invention concerne le domaine des circuits intégrés à semi-conducteurs, comprenant un empilement de couches conductrices séparées par des couches isolantes et leur procédé de fabrication.

Dans de tels circuits intégrés, il est nécessaire d'établir des connexions électriques entre des couches métallisées conductrices de niveaux différents et par conséquent séparées par une ou plusieurs couches isolantes.

De façon connue, deux couches conductrices sont connectées électriquement au moyen de trous prévus dans la couche isolante et remplis de métal, une telle interconnexion étant appelée "Via".

Dans le but de réduire la largeur des lignes de métal d'une couche métallisée conductrice, on souhaite utiliser des lignes dont la largeur est égale à celle des vias.

De tels circuits intégrés peuvent être réalisés selon un procédé appelé "Damascène", dans lequel on dépose une première couche isolante sur une couche de métallisation de niveau n. On effectue la gravure des trous à travers cette couche isolante, on dépose le métal constituant le via et on le polit jusqu'au niveau de la surface supérieure de la couche isolante, puis on dépose une nouvelle couche isolante sur le via de niveau n ainsi constitué, on effectue la gravure des tranchées constituant les futures lignes, on dépose le métal constituant les lignes de la couche de métallisation, puis on polit le métal jusqu'au niveau de la surface supérieure de la couche isolante, etc.

Toutefois, pour des raisons de tolérance d'alignement des équipements de photogravure des trous ou des tranchées dans lesquels sont disposés les vias ou les lignes, il peut se produire un décalage, par exemple de l'ordre du tiers de la largeur d'un trou ou d'une tranchée, un via devant normalement être exactement positionné sur une ligne et une ligne du niveau de métallisation suivant devant, être normalement exactement positionnée sur le via. Il en découle que lors de la gravure d'une couche isolante, le via ou la ligne existant dans la couche isolante inférieure ne constitue pas une barrière d'arrêt de la gravure sur toute la surface de la tranchée ou du trou en cours de gravure. La gravure peut donc s'effectuer sur un côté du via ou de la ligne de la couche inférieure dans ladite couche inférieure sans que l'on puisse contrôler de façon précise la profondeur du trou gravé dans la couche isolante inférieure.

Lorsque le trou de la couche supérieure est ensuite rempli de métal, on ne connaît pas de façon précise la surface de contact entre un via et une ligne. Ainsi, la résistance électrique entre ces deux motifs est mal connue. Dans le cas des lignes, on ne parvient pas à contrôler de façon reproductible la profondeur des tranchées. Il en résulte une dispersion des résistances de ligne.

On connaît aussi un procédé légèrement différent du précédent et cherchant à maîtriser la profondeur des tranchées en évitant tout contact latéral entre des vias et des lignes de niveaux différents. Dans ce procédé, on dispose une couche dite d'arrêt sur la couche isolante inférieure. On effectue alors la gravure des trous dans la couche d'arrêt et dans la couche isolante inférieure, on remplit les trous ainsi créés de métal que l'on polit, puis l'on dépose une couche isolante supérieure puis une couche d'arrêt supérieure. La gravure du trou dans la couche isolante supérieure s'effectue avec un procédé inapte à la gravure de la couche d'arrêt inférieure. La gravure s'arrête sur la surface supérieure de la couche d'arrêt.
Bien entendu, on aura commencé la gravure en utilisant un procédé capable de graver chaque couche d'arrêt. L'épaisseur des couches d'arrêt étant relativement faible par rapport aux couches isolantes auxquelles elles sont associées, on pourra interrompre la gravure avant d'avoir gravé toute l'épaisseur de la couche isolante associée. On termine la gravure de façon sélective par rapport à la couche d'arrêt et au niveau de métallisation associé. Ainsi, le trou dans la couche isolante supérieure est limité par la surface supérieure de la couche d'arrêt inférieure et du niveau de métallisation ou des vias associés. On contrôle ainsi de façon satisfaisante la profondeur de gravure d'un trou ou d'une tranchée, même dans le cas d'un décalage entre les vias et les lignes de deux couches adjacentes. Toutefois, dans le cas d'un décalage, la surface de contact entre un via et une ligne superposés peut se trouver amoindrie, ce qui provoque une augmentation de la valeur de la résistance électrique entre ces deux motifs.

La présente invention a pour objet de remédier aux inconvénients des procédés ci-dessus et de proposer un procédé permettant à la fois un contrôle de la profondeur de gravure et l'obtention de surfaces de contact suffisantes et relativement constantes entre des motifs superposés.

Le procédé de fabrication, selon l'invention, concerne un circuit intégré. Dans ce procédé, on dépose une deuxième couche diélectrique sur une première couche diélectrique, la deuxième couche diélectrique étant susceptible d'être gravée de façon sélective par rapport à la première couche diélectrique, on effectue la gravure de trous ou de tranchées dans les première et deuxième couches diélectriques, et leur remplissage de métal pour constituer des motifs formant des connexions électriques, et on dépose au moins une troisième couche diélectrique. On effectue la gravure de trous ou de tranchées dans la troisième couche diélectrique et dans la couche diélectrique adjacente et inférieure de façon sélective par rapport à la couche diélectrique suivante dans le sens de la gravure et aux motifs pour contrôler la profondeur de la gravure.

Une caractéristique remarquable de l'invention réside dans le fait qu'en cas de décalage entre deux motifs, vias ou lignes, superposés, un contact latéral entre ces deux motifs peut s'établir dans l'épaisseur de la couche diélectrique disposée sous la troisième couche diélectrique, tout en contrôlant la profondeur des tranchées (ou des motifs en général), ce qui permet de maintenir la surface de contact entre ces deux motifs à une valeur sensiblement constante et de mettre ainsi à profit pour améliorer un circuit intégré une caractéristique qui constituait un défaut dans les circuits intégrés de l'art antérieur.

Dans un mode de réalisation de l'invention, on dépose une quatrième couche diélectrique sur la troisième couche diélectrique, la quatrième couche diélectrique étant susceptible d'être gravée de façon sélective par rapport à la troisième couche diélectrique.

On peut graver la quatrième et la troisième couches diélectriques, puis on peut graver la troisième couche diélectrique de façon sélective par rapport à la deuxième couche diélectrique, puis on peut graver la deuxième couche diélectrique de façon sélective par rapport à la première couche diélectrique.

Dans un autre mode de réalisation de l'invention, on dépose une couche diélectrique supplémentaire sur la deuxième couche diélectrique. On peut ensuite graver sélectivement la troisième couche diélectrique et la couche diélectrique supplémentaire par rapport à la deuxième couche diélectrique et remplir ensuite les trous de métal pour constituer des motifs formant des connexions électriques, par exemple des vias connectant des pistes de deux niveaux de métallisation voisins n+1, n+2 ou des lignes d'un niveau de métallisation donné.

On peut réitérer les étapes précédentes pour constituer les couches, les lignes et les vias des niveaux de métallisation suivants, n+1 et n+2.

Enfin, on peut réitérer les étapes précédentes pour constituer les éléments des niveaux de métallisation successifs, n+2 et n+3, n+3 et n+4, etc.

La présente invention a également pour objet un circuit intégré dont la résistance électrique entre vias superposés est sensiblement constante.

Le circuit intégré, selon l'invention, comprend des pistes de différents niveaux de métallisation séparés par des couches diélectriques et des vias métallisés connectant des pistes de deux niveaux de métallisation voisins, les vias métallisés prévus entre les niveaux de métallisation n et n+1 comprenant une surface supérieure affleurant le niveau de métallisation n+1. Le circuit intégré comprend au moins deux couches diélectriques superposées, et au moins un motif prévu dans une troisième couche diélectrique disposée au dessus des précédentes et traversant la couche diélectrique adjacente et inférieure à la troisième couche jusqu'au contact avec la couche adjacente et inférieure à la couche adjacente et inférieure à la troisième couche.

Avantageusement, les motifs métallisés comprenant une surface latérale adjacente à leur surface supérieure, au moins un motif, via ou ligne, comprend une portion disposée au niveau de la couche diélectrique adjacente et inférieure à la troisième couche, en contact avec la surface latérale du motif correspondant prévu dans lesdites deux couches. On contrôle ainsi de façon satisfaisante l'épaisseur des lignes et, par conséquent, leur résistance électrique.

Dans un mode de réalisation de l'invention, les couches disposées entre les niveaux de métallisation successifs, n+1/n+2, n+2/n+3, etc., sont de construction semblable à celles des niveaux de métallisation n et n+1.

La présente invention sera mieux comprise et d'autres avantages apparaîtront à la lecture de la description détaillée de quelques modes de réalisation pris à titre d'exemples nullement limitatifs et illustrés par les dessins annexés, sur lesquels :
la figure 1 est une vue schématique en coupe d'un circuit intégré selon l'art antérieur;
la figure 2 est une vue schématique en coupe selon un autre art antérieur;
les figures 3a à 3h et 3e' à 3h' sont des vues schématiques en coupe montrant les étapes de fabrication d'un circuit intégré selon l'invention; et
les figures 4a à 4h et 4e' à 4h' montrent une variante des figures précédentes.

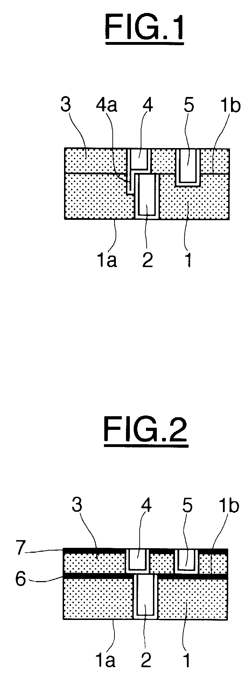

Comme on peut le voir sur la figure 1, une couche diélectrique inférieure 1 est pourvue d'un via 2 la traversant sur son épaisseur et permettant la connexion électrique entre un niveau de métallisation adjacent à sa face inférieure la et un niveau de métallisation adjacent à sa face supérieure 1b. Une couche diélectrique supérieure 3 recouvre la face supérieure 1b de la couche diélectrique inférieure 1 et est pourvue de deux lignes 4 et 5. Les lignes 4 et 5 sont disposées dans des tranchées gravées dans l'épaisseur de la couche diélectrique supérieure 3 et forment un niveau de métallisation.

Pour garantir que ces tranchées soient de profondeur suffisante pour atteindre la face supérieure 1b, on poursuit l'étape de gravure pendant une durée telle que l'on soit sûr que l'on a atteint ce niveau. Il en résulte en fait que la gravure est effectuée également sur une partie de l'épaisseur de la couche inférieure 1. Toutefois, on ne connaît pas avec précision quelle est l'épaisseur ainsi gravée.

Il arrive fréquemment que les vias et les lignes des deux couches diélectriques superposées soient décalés. On voit ainsi que la ligne 4 est décalée d'environ un tiers de sa largeur par rapport au via 2.

Lors de la gravure de la tranchée prévue pour les lignes 4 et 5, le via 2 provoque l'arrêt de la gravure. Mais celle-ci se poursuit néanmoins, en raison du décalage, sur le côté du via 2 jusqu'à une profondeur que l'on ne maîtrise pas de façon précise. (la profondeur de la tranchée 5 est également non maîtrisée)

Lors du dépôt du métal constituant les lignes 4 et 5, la portion de trou disposée sur le côté du via 2 se remplit également de métal et constitue une portion 4a de la ligne 4 disposée sous la surface supérieure 1b de la couche inférieure 1 et adjacente au via 2.

Comme l'on ne connaît pas précisément l'épaisseur gravée dans la couche inférieure 1 lors de la gravure de la couche supérieure 3 et par conséquent l'épaisseur de la portion de ligne 4a, on ne peut pas non plus connaître avec précision la surface de contact entre le via 2 et la ligne 4. En effet, le contact s'effectue non seulement par les surfaces du via 2 et de la ligne 4 affleurant la face supérieure 1b de la couche inférieure 1, mais aussi par le bord du via 2 et la portion de ligne 4a.

Le circuit intégré représenté sur la figure 2 a reçu une couche d'arrêt 6 déposée sur la surface supérieure 1b de la couche inférieure 1 et supportant un niveau de métallisation, non représenté. La couche d'arrêt 6 peut être composée de nitrure, tandis que la couche diélectrique 1 peut être composée d'oxyde de silicium. La couche d'arrêt 6 peut aussi être composée d'oxyde de silicium de forte densité et la couche diélectrique 1 peut être composée d'un isolant de permittivité électrique plus faible.

On recherche d'une façon générale, pour la couche d'arrêt 6, un matériau qui puisse ne pas être gravé tandis qu'une couche diélectrique adjacente l'est.

Le via 2 est déposé dans l'épaisseur de la couche inférieure 1 et de la couche d'arrêt 6. La couche diélectrique supérieure 3 reçoit également une couche d'arrêt 7, les lignes 4 et 5 étant déposées à travers la couche supérieure 3 et le couche d'arrêt 7.

Lorsque l'on effectue la gravure de la couche d'arrêt 7 et de la couche supérieure 3, on utilise tout d'abord un procédé capable de graver la couche d'arrêt 7, puis une fois la couche d'arrêt 7 gravée, on utilise un autre procédé capable de graver la couche diélectrique supérieure 3, mais sélectif vis-à-vis du via 2 et de la couche d'arrêt 6. La gravure s'arrête donc sur une surface plane formée par la couche d'arrêt 6 et le via 2.

Lors d'un décalage des trous et des vias entre deux couches superposées adjacentes, il en résulte que le contact entre le via 2 et la ligne 4 ne s'effectue que par une surface plane commune au via 2 et à la ligne 4, et par conséquent réduite par rapport à la surface de l'un de ces deux motifs. Cette diminution de la surface de contact entre le via 2 et la ligne 4 se traduit par une augmentation de la résistance électrique entre ces motifs, ce qui est néfaste au bon fonctionnement du circuit intégré, par contre la profondeur des lignes est contrôlée.

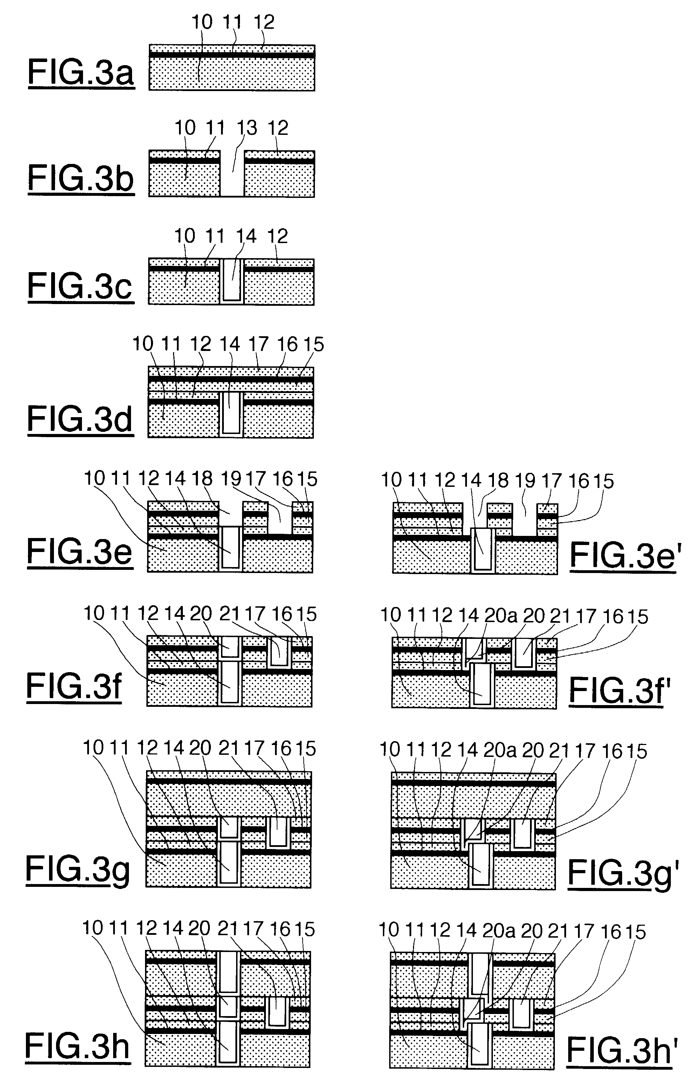

Comme on peut le voir sur les figures 3a à 3h, on commence tout d'abord (étape A), par déposer une première couche diélectrique 10 sur une couche de métallisation, non représentée, de niveau n. On dépose ensuite une deuxième couche diélectrique 11 dite d'arrêt de faible épaisseur par rapport à la couche diélectrique 10. Sur la couche d'arrêt 11, on dépose une couche diélectrique supplémentaire 12 également de faible épaisseur.

Ensuite (étape B), on effectue la gravure des trous 13 en utilisant un procédé capable de graver les couches diélectriques 10, 11 et 12, ou bien une succession de procédés différents.

A l'étape C, on remplit le trou 13 de métal constituant le via 14.

A l'étape D, on dépose sur la couche diélectrique supplémentaire 12 et le via 14 une troisième couche diélectrique 15, puis une quatrième couche diélectrique 16, puis une couche diélectrique supplémentaire 17.

Ensuite, à l'étape E, on effectue de façon non sélective la gravure de la couche diélectrique supplémentaire 17 et de la quatrième couche diélectrique 16, puis de façon sélective la gravure de la troisième couche diélectrique 15 et de la couche diélectrique supplémentaire 12 par rapport à la deuxième couche diélectrique 11. On obtient ainsi des tranchées 18 et 19, la tranchée 18 s'arrêtant, en l'absence de décalage, sur l'extrémité supérieure du via 14 et la tranchée 19 s'arrêtant sur la deuxième couche diélectrique 11.

A l'étape F, on effectue le remplissage de métal dans les tranchées 18 et 19 pour constituer les lignes 20 et 21.

On peut ensuite répéter l'opération (étapes G et H) de façon similaire, pour constituer un empilement de niveaux de métallisation séparés par des couches diélectriques. L'épaisseur des couches diélectriques peut varier selon le niveau de métallisation.

Au contraire, en présence d'un décalage (étape E'), la gravure de la tranchée 18 s'arrête partiellement sur le via 14 et partiellement sur la deuxième couche diélectrique 11. La profondeur de cette gravure supplémentaire entre le via 14 et la deuxième couche diélectrique 11 est connue et égale à l'épaisseur de la couche diélectrique supplémentaire 12. On effectue ensuite le dépôt de métal dans les tranchées 18 et 19 (étape F') pour constituer les lignes 20 et 21, la ligne 20 comportant alors une portion 20a s'étendant sur l'épaisseur de la couche diélectrique supplémentaire 12 sur une surface latérale du via 14 adjacente à la surface d'extrémité du via 14. Le contact entre le via 14 et la ligne 20 s'effectue à la fois par l'extrémité du via 14 et par sa surface latérale adjacente sur une hauteur toujours constante de ladite surface latérale. Il en résulte que l'on connaît avec précision la surface de contact entre le via 14 et la ligne 20 et qu'on connaît donc également avec précision la valeur de la résistance entre le via 14 et la ligne 20. On connaît également la profondeur de la ligne 21 et donc la valeur de sa résistance. Les mêmes étapes peuvent se répéter (étapes G' et H') pour l'obtention d'un circuit intégré comprenant un grand nombre de couches.

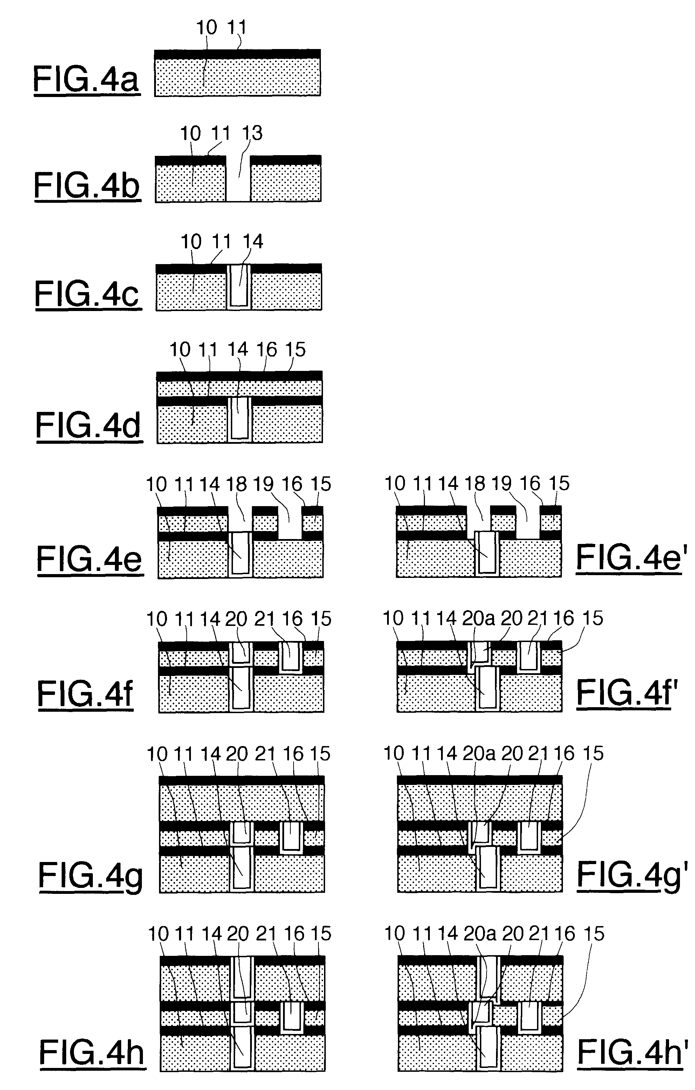

Sur les figures 4a à 4h et 4e' à 4h', est illustrée une variante de l'invention dans laquelle la première couche diélectrique 10 est recouverte d'une deuxième couche diélectrique 11 dite d'arrêt d'épaisseur importante (étape A).

A l'étape B, on effectue la gravure de la deuxième couche diélectrique 11 et de la première couche diélectrique 10 pour obtenir un trou 13 que l'on remplit de métal pour constituer le via 14 (étape C).

A l'étape D, on dépose une troisième couche diélectrique 15, puis une quatrième couche diélectrique 16 sur la deuxième couche diélectrique 11 et le niveau de métallisation n+1.

A l'étape E, on grave la quatrième couche diélectrique 16 et la troisième couche diélectrique 15 de façon non sélective, puis on grave la troisième couche diélectrique 15 de façon sélective par rapport à la deuxième couche diélectrique 11, et enfin on grave la deuxième couche diélectrique 11 de façon sélective par rapport à la première couche diélectrique 10. On obtient ainsi les tranchées 18 et 19 qui se présentent selon une configuration proche de celle des figures 3a à 3h, avec ou sans décalage. Les tranchées 18 et 19 peuvent alors être remplies de métal pour constituer les lignes 20 et 21 (étape F), le procédé pouvant être réitéré pour les couches suivantes de façon à former un circuit intégré comportant de nombreux niveaux de métallisation.

Par rapport au mode de réalisation de la figure 3a à 3h, on remarque que la structure du circuit intégré est plus simple dans la mesure où l'on supprime une couche diélectrique intermédiaire entre deux niveaux de métallisation. En contrepartie, la couche 11 est plus épaisse, ce qui peut augmenter les capacités parasites inter-lignes.

Grâce à l'invention, on dispose d'un circuit intégré dont on maîtrise de façon satisfaisante la valeur des résistances des vias et des lignes superposés, ce qui permet un accroissement des performances du circuit intégré et une amélioration de la qualité par une diminution du nombre de défauts.

Le procédé de fabrication mis en oeuvre pour parvenir à ce circuit intégré est relativement simple et peut être effectué avec des équipements existants.

## Revendications

1. Procédé de fabrication d'un circuit intégré dans lequel on dépose une deuxième couche diélectrique (11) sur une première couche diélectrique (10), la deuxième couche diélectrique étant susceptible d'être gravée de façon sélective par rapport à la première couche diélectrique, on effectue la gravure de trous ou de tranchées (13) dans les première et deuxième couches diélectriques, et leur remplissage de métal pour constituer des motifs formant des connexions électriques, et on dépose au moins une troisième couche diélectrique (15), caractérisé par le fait qu'on effectue la gravure de trous ou de tranchées dans la troisième couche diélectrique et dans la couche diélectrique adjacente et inférieure de façon sélective par rapport à la couche diélectrique suivante et aux motifs pour contrôler la profondeur de la gravure.

2. Procédé selon la revendication 1, caractérisé par le fait qu'on dépose sur la troisième couche une quatrième couche diélectrique, la quatrième couche diélectrique (16) étant susceptible d'être gravée de façon sélective par rapport à la troisième couche diélectrique (15).

3. Procédé selon la revendication 2, caractérisé par le fait qu'on grave la quatrième et la troisième couches diélectriques, puis on grave la troisième couche diélectrique de façon sélective par rapport à la deuxième couche diélectrique, puis on grave la deuxième couche diélectrique de façon sélective par rapport à la premième couche diélectrique.

4. Procédé selon la revendication 1, caractérisé par le fait qu'on dépose une couche diélectrique supplémentaire (12) sur la deuxième couche diélectrique (11).

5. Procédé selon la revendication 4, caractérisé par le fait qu'on grave sélectivement la troisième couche diélectrique (15) et la couche diélectrique supplémentaire (12) par rapport à la deuxième couche diélectrique (11) et qu'on remplit ensuite les trous de métal pour constituer des motifs formant des connexions électriques.

6. Procédé selon l'une quelconque des revendications précédentes, caractérisé par le fait que l'on réitère les étapes précédentes pour constituer les couches, les lignes et les vias des niveaux de métallisation suivants, n+1 et n+2.

7. Procédé selon la revendication 6, caractérisé par le fait que l'on réitère les étapes précédentes pour constituer les éléments des niveaux de métallisation successifs, n+2 et n+3, n+3 et n+4 etc.

8. Circuit intégré comprenant des pistes de différents niveaux de métallisation séparés par des couches diélectriques et des vias métallisés connectant des pistes de deux niveaux de métallisation voisins, les vias métallisés (14) prévus entre les niveaux de métallisation n et n+1 comprenant une surface supérieure affleurant le niveau de métallisation n+1, **caractérisé par le fait** qu'il comprend au moins deux couches diélectriques superposées et au moins un motif prévu dans une troisième couche diélectrique disposée au dessus des précédentes et traversant la couche diélectrique (12) adjacente et inférieure à la troisième couche jusqu'au contact avec la couche adjacente et inférieure à la couche adjacente et inférieure à la troisième couche.

9. Circuit selon la revendication 8, caractérisé par le fait que, les motifs métallisés comprenant une surface latérale adjacente à leur surface supérieure, au moins un motif comprend une portion (20a) disposée au niveau de la couche diélectrique (12) adjacente et inférieure à la troisième couche en contact avec la surface latérale du motif correspondant prévu dans lesdites deux couches.

10. Circuit selon la revendication 8 ou 9, caractérisé par le fait que les couches disposées entre des niveaux de métallisation successifs, n+1/n+2,n+2/n+3,etc sont de construction semblable à celles disposées entre les niveaux de métallisation n et n+1.
